# EUROPEAN PATENT SPECIFICATION

(11) **EP 2 372 743 B1**
(45) Date of publication and mention of the grant of the patent: **23.03.2016**
(21) Application number: 11172096.7
(22) Date of filing: 18.09.2003
(51) Int. Cl.: H01J 37/00, H01J 37/244, H01J 37/26

(54) **CHARGED PARTICLE BEAM SYSTEM WITH AN ION GENERATOR**
TEILCHENSTRAHLSYSTEM MIT IONENGENERATOR
SYSTÈME À FAISCEAU DE PARTICULES CHARGÉES, AVEC GÉNÉRATEUR D'IONS

(30) Priority: 18.09.2002 US 411699 P; 27.12.2002 US 330691
(43) Date of publication of application: 05.10.2011
(62) Divisional of application: 03797915.0
(73) Proprietor: FEI Company, Hillsboro, OR 97124-5793 (US)
(72) Inventor: Stewart, Diane, 5602 BS Eindhoven (NL); Knowles, Ralph, 5602 BS Eindhoven (NL); Kimball, Brian, 5602 BS Eindhoven (NL)
(74) Representative: Bakker, Hendrik

(56) References cited:
- US-A- 4 249 077
- US-A- 5 396 067

## Description

### Technical Field of the Invention

The present invention relates to the field of charged particle beam tools for forming, altering and viewing microscopic structures.

### Background of the Invention

Photolithography is a process that is used to create small structures, such as integrated circuits and micromachines. The photolithography process entails exposing a radiation-sensitive substance, called photoresist, to a pattern of light or other radiation. The pattern is typically created by passing the radiation through a mask, that is, a substrate having a pattern on the surface. The pattern blocks some of the radiation or changes its phase to create exposed and unexposed areas on the radiation-sensitive material. The size of the structure that can be produced is limited by the wavelength of radiation used; shorter wavelengths can produce smaller structures.

As photolithography processes are called upon to produce ever-smaller structures, lithography systems are being developed that use smaller wavelengths of radiation, including infrared and even x-ray radiation. (The terms "light" and "photolithography" are used in a general sense to also include radiation other than visible light.) Photolithography Systems are now being developed that can produce structures having dimensions of 70 nm and smaller. Such structures can be fabricated using light having a wavelength of 193 nm or 157 nm. Some photolithography masks for such short wavelengths use a reflective, rather than a transmissive, pattern on the mask because the mask substrate is not sufficiently transparent to such radiation of small wavelengths. In such masks, radiation is reflected from the mask onto the photoresist.

A photolithography mask must be free of imperfections if the mask is to accurately produce the desired exposure pattern. Most newly fabricated masks have defects such as missing or excess pattern material. Before such masks can be used, the defects are repaired, often by using a charged particle beam system. Dual beam systems that include an ion beam and an electron beam can be used in mask repair. The ion beam is used to etch away excess material on the mask to deposit material onto the mask, or to form images of the mask. The electron beam is also used to form images of the mask and sometimes to deposit or etch material. When a charged particle beam is applied to a mask, which is typically fabricated on an insulating substrate, electrical charge tends to accumulate on the substrate. The electric charge adversely affects the operation of the charge particle beam by affecting the shape and positioning of the beam spot.

One method of neutralizing or reducing accumulated charge entails using an electron flood gun to direct electrons at a positively charged substrate. Such a system is described, for example in U.S. Pat. No. 4,639,301 to Doherty et al. Another method, described in C. K. Crawford in "Charge Neutralization Using Very Low Energy Ions," Scanning Electron Microscopy/1979/II, is to use a beam of very low energy positive ions to neutralize a build-up of negative charges. The ions are generated by a high voltage that ionizes a gas within an ion generator, so the number of ions produced in Crawford's system is determined by factors unrelated to the charge accumulation on the work piece. Such systems were not easy to use because they needed to be balanced for any change in operational conditions. Use of such systems declined with the introduction of low vacuum SEMs and ESEMS and with the increased use of field emission gun SEMs, which allowed satisfactory imaging at lower voltages, thereby reducing work piece charging.

Similarly, US 4 249 077 A discloses (see Fig. 2, 3, and related description) a charged particle beam apparatus (scanning electron microscope) with all features of the preamble of claim 1, in particular an ion generator 30 including a chamber 36 containing a gas and connected to the work piece vacuum chamber though an aperture that allows ions to exit the chamber to neutralize charge on the work piece.

Further, US 5 396 067 A (Fig. 3, 4) discloses a scanning electron microscope with a gas amplification ion generator between a pressure limiting aperture 3 and an aperture plate 19 above a work piece. Secondary particles generated by the impact of the electron beam on the work piece ionize an ion producing gas in the ion generator.

It is a common technique to use a charged particle beam to form an image of the work piece by collecting secondary or back scattered particles emitted as the primary beam scans the work piece surface. The brightness of each point on the image corresponds to the number of secondary particles collected as the beam impacts each point on the substrate. (The term "secondary particle" is used herein to include any particle coming off of the work piece, including back-scattered particles.) Electrical charging of the insulating substrate affects imaging by affecting the paths of secondary particles.

One technique for detecting secondary particles emitted by the impact of a primary electron beam is described in US. Pat. No. 4,785,182 to Mancuso, et al., which describes a secondary electron detector for use in an environmental scanning electron microscope ("ESEM"). The detector device consists of an electrode, to which an electrical potential is applied to produce an electric field. Secondary particles emitted at the substrate are accelerated toward the detector and collide with gas molecules, producing additional charged particles, which in turn collide with other gas molecules to produce even more charged particles. Such a process is called a "cascade" effect. The ultimate number of charged particles produced in this manner is proportional to the number of secondary particles emitted at the substrate, thereby producing an amplified signal corresponding to the number of secondary particles. The electron source and much of the path of the primary beam is maintained at a high vacuum by an aperture that passes the primary beam but prevents most gas molecules from entering the column.

In an ESEM detector, the path length of the secondary particles through the detector gas must be sufficiently long to allow enough collisions with gas molecules to provide adequate amplification. To increase the probability of collisions, detectors are typically provisioned away from the work piece to provide a relatively long path length as the particles move from the work piece to the detector. Increasing the gas pressure also increases the probability of a collision while traveling of a particular path. Gas pressure in an ESEM is typically maintained at around 0.65 to 6.5 mbar (0.5 to 5 Torr) between the work piece and the detector to provide sufficient gas molecules to produce the cascade effect.

Another way of increasing amplification is to provide a magnetic field that causes the particles to move in a curved path or loops within the gas. US Pat. No. 6,184,525 to van der Mast describes the use of an electrostatic multipole structure to increase the path length of the secondary electrons to increase the probability of collisions with the gas molecules. Similarly, U.S. patent 6,365,896 to Van der Mast describes adding an additional magnetic fields between the detector and the specimen holder to lengthen the path of the secondary electrons even further to produce a higher degrees of ionization. Both van der Mast patents are assigned to the assignee of the present application. Japanese Pat. Publication No. 5-174768 also describes an ESEM with a detector positioned in the magnetic field of an objective lens of an electron microscope to increase amplification. Japanese Pat. Publication No. 5-174768 also describes that ions generated by the detector of an environmental scanning electron microscope can neutralize charge build-up on a work piece.

The relatively high gas pressure required for an ESEM detector makes such system unsuitable for use in the same vacuum chamber as another charged particle beam system, such as an ion beam system or a non-ESEM SEM, because most charged particle beam systems cannot operate at the relatively high gas pressures required by an ESEM. The gas molecules interfere with the ions or electrons in the beam, reducing resolution or degrading signal to noise ratio.

### Summary of the Invention

An object of the invention is to provide a system for imaging or processing microscopic structures, and is particularly useful for, though not limited to, imaging or processing microscopic structures on a insulating substrate using a multiple beam system in which at least one column includes an ion generator.

The invention provides an apparatus and a method as defined in independent claims 1 and 9. Preferred embodiments are set out in the dependent claims.

In some embodiments, an ion generator generates ions that neutralize charge on a work piece while maintaining a relatively low gas pressure in the vacuum chamber away from the ion generator. The pressure is sufficiently high at the ion generator to generate ions by collisions of secondary particles with the gas molecules, while being sufficiently low in the remainder of the vacuum chamber so that the time required to evacuate the system to a pressure suitable for operating a non-ESEM charged particle beam system is greatly reduced compared to the time required to evacuate the chamber from the operating pressure of the ESEM.

The foregoing has outlined rather broadly some of the features and technical advantages of various aspects of a preferred system of the present invention in order that the detailed description of the invention that follows may be better understood. Additional features and advantages of the invention will be described hereinafter. It should be appreciated by those skilled in the art that the conception and specific embodiment disclosed herein may be readily utilized as a basis for modifying or designing other structures for carrying out the same purposes of the present invention. It should also be realized that while a preferred system for repairing photomasks may implement many of the inventive aspects described below, many of the inventive aspects could be applied independently, or in any combination, depending upon the goals of a specific implementation

### Brief Description of the Drawings

For a more thorough understanding of the present invention, and the advantages thereof, reference is now made to the following descriptions taken in conjunction with the accompanying drawings, in which:
FIG. 1A is a schematic showing a dual beam system embodiment of the invention in which two charged particle beam optical columns are oriented approximately parallel to each other. FIG. 1 B is a schematic showing a dual beam system embodiment of the invention in which two charged particle beam optical columns are not oriented parallel to each other.
FIG. 2 is a schematic showing an example not forming part example not forming part of the invention that includes a dual beam system when used with an electron column with an immersion magnetic objective lens.with an ESEM detector that generates ions.
FIG. 3 shows an embodiment of the invention that uses an ion generator for charge neutralization when used with an electron column with a non-immersion magnetic objective lens.
FIGS. 4A and 4B show electron beam images of a binary mask, FIG. 4A showing an image taken when the mask electrically charged and FIG. 4B showing an image taken the charge neutralized in accordance with an ESEM-type neutralizer.
FIGS. 5 and 6 show the magnetic and electric field structure of an ion generator or detector suitable for use with a magnetic immersion lens, and the trajectory of an electron in this field structure
FIG. 7 shows an example not forming part of the invention using an ESEM detector with an immersion lens.
FIG. 8 shows an example not forming part of the invention in which a gas passage is incorporated into an ESEM detector with the work piece close to the detector.
FIG. 9 shows an example not forming part of the invention in which a gas passage is incorporated through the anode of an ESEM detector.

### Detailed Description of the Preferred Embodiments

A preferred embodiment of the invention uses an ion generator to neutralize negative charge in insulating samples in a charged particle beam system. Because photolithography masks are typically fabricated on an insulating substrate, such as quartz, the invention is useful for charged particle beam operations on photolithography masks.

The ion generator uses secondary or backscattered electrons emanating from the work piece to ionize a gas, in a manner similar to the way a detector works in an environmental scanning electron microscope (ESEM). The secondary particles collide with and ionize the gas molecules as the particles pass through the gas. The ionized gas molecules then collide with and ionize other gas molecules in a cascading reaction. This ion generation process can generate large quantities of ions for use in stabilizing the charge on insulating samples or for imaging.

By using secondary particles from the work piece to generate the ions, the number of ions generated will be related to the amount of charging on the work piece. The electrical potential of the work piece, which varies with the accumulated charge, also works to automatically regulate the number of ions reaching the work piece. The system can thus provide a self-stabilizing ion generator for neutralizing charge on a work piece in charged particle beam system. Once the gas pressure and ion generator are set-up for controlling the charge, then other microscope parameters, such as beam energy, scan speed, and beam current, can be altered without upsetting the control - the system can be self-regulating.

Some embodiments of the invention use an environmental scanning electron microscope (ESEM) detector, which generates ions to amplify the secondary electron signal. Examples not forming part of the invention use an ESEM detector to also provide ions for neutralizing charge on the work piece. Embodiments of the invention use an ion generator that is a separate device, not connected with an ESEM detector.

Although an ESEM generates ions, and those ions can be used for charge neutralization, ESEMs have been unsuitable for use in a multiple beam system, such as a dual beam system including an ESEM and a focused ion beam (FIB) column. ESEMs typically operate at pressures of about 0.65 to 6.5 mbar (0.5 to 5 Torr), whereas a focused ion beam typically operates at pressures of about 1.3x10⁻⁵ mbar (10⁻⁵ Torr). Thus, in a dual beam system containing an ESEM and a focused ion beam column, the user would have to reduce the pressure in the sample vacuum chamber from 0.65 mbar to 1.3x10⁻⁵ mbar (0.5 Torr to 10⁻⁵ Torr) when switching from using the ESEM to using the FIB. The time required to pump the vacuum chamber down from 0.65 mbar to 1.3x10⁻⁵ mbar (0.5 Torr to 10⁻⁵ Torr) is a serious disadvantage to using an ESEM together with a FIB in most commercial applications. Even if an ESEM detector uses a gas jet positioned in the detector area, rather than flooding the chamber with the detector gas, the chamber still fills with the detector gas, which must be evacuated before using the ion beam.

Some embodiments of the invention make practical the use of an ESEM and a FIB or SEM in the same vacuum chamber. In some example not forming part of the invention, the system design tends to localize the gas in a comparatively small volume near the ion generator. In such examples the system maintains a different pressure at different locations in the system so that the gas pressure is higher at the location where ions are to be generated, and lower at other parts of the system so as to reduce interference with the charged particle beams. For example, when the pressure in a small volume near the ESEM detector is about 0.65 mbar (0.5 Torr), the background pressure in the chamber is maintained at about 1.3x10⁻⁴ mbar (10⁻⁴ Torr) pressure. When switching to the FIB, the chamber then only needs to be pumped from 1.3x10⁻⁴ mbar to 1.3x10⁻⁵ mbar (10⁻⁴ Torr to 10⁻⁵ Torr), instead of from 0.65 mbar to 1.3x10⁻⁵ mbar (0.5 Torr to 10⁻⁵ Torr). Thus, switching from ESEM operation to FIB operation is much quicker, and a dual beam ESEM-FIB is practical for mask repair and other applications. In some embodiments, it may be possible to operate the ESEM detector or other ion generator and FIB simultaneously.

By returning some of the ions generated by the ESEM detector or other ion generator to the work piece to neutralize charge, the ESEM or other imaging system can produce images that show features on chrome absorbers with a resolution of less than 2 nm. The charge neutralization provided by the ion generator can be controlled in part by controlling the pressure and identity of the gas or gas mixture. The gases or gas mixtures used for ion generation can also be used for charged particle beam assisted etching or deposition to repair defects. The use of gases for etching or deposition in the presence of a charged particle beam is referred to "beam chemistry." In some embodiments, gases coming from the ion generator for charge neutralization can alternate with different gases for etching or deposition, and in other embodiments gas mixtures may be used.

Different electron final lens configurations will typically require different designs to produce ions for neutralization for secondary particle detection and/or charge neutralization. The several embodiments described below provide example of designs that can be used with different types of electron lenses and, by using these examples and the principals disclosed, skilled persons can design detection/neutralization configurations to work with other types of lenses.

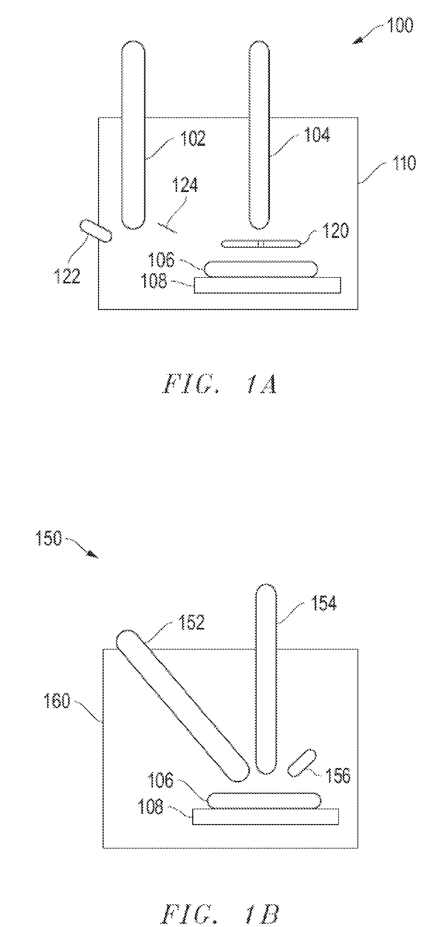

FIG. 1A shows schematically a dual beam system 100 that can be used, for example, for advanced mask repair and metrology and that can incorporate the present invention. The invention is not limited to use in a dual beam system, but can be used in a single beam system or a multiple beam system. System 100 comprises a first charged particle beam column 102 and a second charged particle beam column 104, the axes of columns 102 and 104 being oriented approximately parallel to each other and approximately normal to the surface of a work piece 106. A work piece holder or stage 108 can move the work piece 106 to accurately position it under either column. Columns 102 and 104 and work piece 106 are contained within a vacuum chamber 110.

The invention is not limited to any particular types of columns. For example, an embodiment of the invention could comprise any combination of ion beam columns, such focused beams columns or shaped beam columns, and electron beam columns, such as ESEM and non-ESEM columns. The term ESEM as used herein applies broadly to any electron column configuration that uses the ionization of gas by secondary electrons or backscattered electrons to generate ions for detection, for charge neutralization, or for both.

FIG. 1A shows, for example, an ESEM detector 120 used with immersion lens column 104 and a separate ion generator 122 used with non-immersion lens column 102 for charge neutralization. Column 102 also includes a non-ESEM secondary particle detector 124, such as a scintillator detector or a channel plate detector. The two electron columns offer different views of the sample. The immersion lens column gives a high resolution image with a symmetrical detector, whereas the non-immersion column allows for detectors that offer a directional component to the image. Different implementation could use different combinations of ESEM detectors, non-ESEM detectors, and ion generators.

FIG. 1 B shows a system 150 in which a first charged particle beam column 152 and a second charged particle beam column 154 are arranged such that their beams are coincident or nearly so. That is, one column is tilted with respect to the other column, so that both beams impact the work piece at the same, or nearly the same, point. If the impact points are offset, work piece hold 108 can move the work piece 106 to accurately position it under the impact point of either column. Columns 152 and 154 and work piece 106 are contained within a vacuum chamber 160. Column 152 and 154 can use any combination of non-ESEM ion generator, and conventional detectors, although the tilt of one column may physically make some combinations difficult to implement. FIG. 1 B shows a charge generator 156 that provides charge neutralization.

At least one of the two columns in a dual beam system used for mask repair is preferably tilted or tiltable with respect to the work piece surface. Using a tilted beam can provide three-dimensional information about the work piece. Three-dimensional information is useful, for example, in the repair of quartz bumps defects on a phase shift mask. Such defects, being made of the same material as the substrate, do not exhibit much contrast with the substrate in an image, and so can be difficult to repair without damaging the substrate. US2004121069A "Repairing Defects On Photomasks Using A Charged Particle Beam And Topographical Data From A Scanning Probe Microscope," describes a method of using three-dimensional topographical information to repair defects in phase shift masks. A tilted charged particle beam can be used to provide a three-dimensional image instead of the scanning probe microscope described in US2004121069A. If a charged particle beam system provides the three-dimensional data, it becomes unnecessary to remove the work piece from the vacuum chamber to obtain the information, thereby improving productivity.

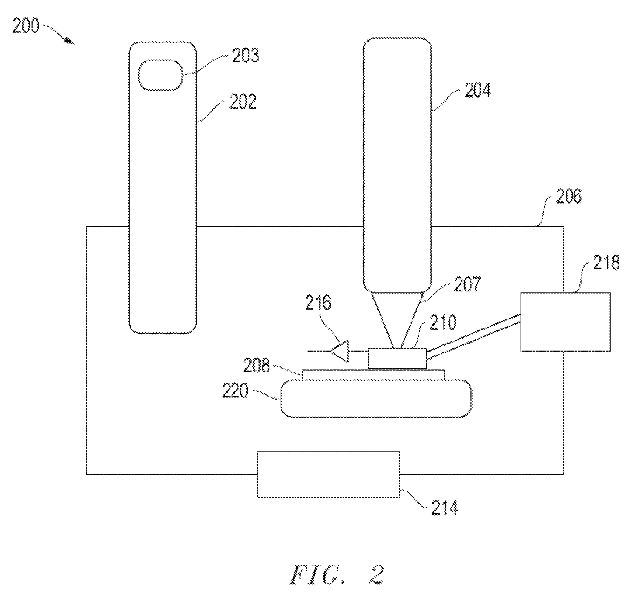

FIG. 2 shows a system 200 that includes an ion beam column 202 and an environmental scanning electron microscope column 204 positioned within a vacuum chamber 206. Environmental scanning electron microscope column 204 includes a magnetic immersion objective lens 207, which has a high magnetic field at the work piece. Focused ion beam column 202 includes an ion source 203, preferably a gallium liquid metal ion source (LMIS). The example is not limited to any particular type of ion source, and other ion sources could be used, such as a silicon/gold eutectic LMIS or a plasma ion source. Ion beam column 202 can use a focused beam or a shaped beam. Ion beam column 202 can be used to remove material from the surface of a work piece 208, either by sputtering or by chemical-assisted etching, or to deposit material on the surface of a work piece 208, using ion beam assisted deposition in which a precursor gas is decomposed in the presence of the ion beam to leave a deposit on the surface. The combination of the large flat detector 210 and the large flat work piece 208 provides some containment for the detector gas, making it possible for a vacuum pump 214 to maintain a pressure between detector 210 and work piece 208 that is several orders of magnitude higher than the general pressure in other parts of chamber 204.

ESEM column 204 includes an ESEM-type detector 210 connected to an amplifier 216 and a gas injector 218 that provides the gas used to amplify the secondary particles emitted from work piece 208. The gas can also be used for chemical assisted electron beam etching or deposition. Stage 220 positions the work piece 208 under either column 202 or column 204, as desired.

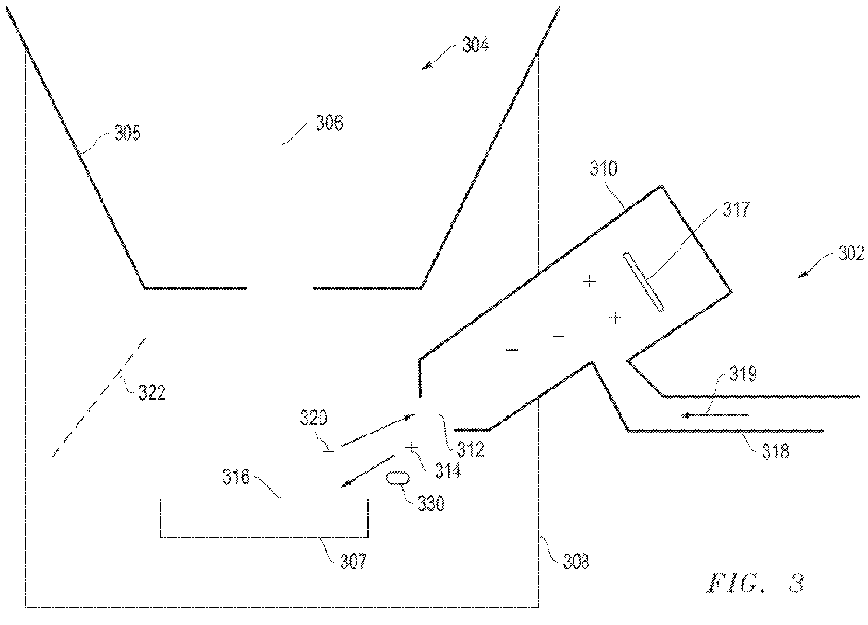

FIG. 3 shows an embodiment of the invention using a self-stabilizing ion generator for neutralizing charge accumulated on the work piece by operation of an electron beam column with a non-immersion lens (i.e., a lens with low magnetic field at the work piece). FIG. 3 shows an electron beam column 304 including a non-immersion objective lens 305 that focuses an electron beam 306 onto the work piece 307, which is enclosed in a system vacuum chamber 308 that may also contain a second charged particle beam column, such as a focused ion beam system.

The ion generator 302 comprises an enclosed tube 310 having an orifice 312 to let ions 314 leave tube 310 to reach impact point 316 where electron beam 306 impacts work piece 307. A high voltage electrode 317 accelerates the secondary particles within tube 310. A pipe 318 brings gas as shown by arrow 319 into tube 310.

The ion generator tube 310 is preferably maintained at a small positive bias voltage, preferably between about 10 V and about 500 V, and typically at about 200 V, to attract some of secondary electrons 320 into the tube. High voltage electrode 317, which is preferably maintained at a potential of between about 300 V and about 2000 V, and typically at about 500 V, further accelerates secondary electrons 320 within tube 310 to trigger gas ionization cascades in tube 310. The ions 314 flow away from the electrode 317 and out of the orifice. The positive bias on the tube (and any sample charging) accelerates the ions towards the sample. If there were an excess of ions, the sample would become positively charged, which would reduce the ion flow to the sample and cause the excess ions to flow to the objective lens or back to the tube. Thus, the neutralization is self-regulating. The self regulation may be enhanced by the addition of an electrode which may be grounded or biased to cause the excess ions to flow to the electrode rather than the lens

The collection and detection of the majority of secondary particles for imaging and analysis can be performed using any conventional high vacuum detector 322, such as a scintillator detector or a channel plate detector. Secondary particles can be collected off-axis near the work piece as shown in FIG. 3 or through the lens. Thus, by using ion generator 302, one can achieve a system that can use non-ESEM detectors, while providing charge neutralization by an ion generator. The vacuum chamber is not flooded with a gas that would preclude operating a non-ESEM-type charged particle beam, either simultaneously or after a relatively brief pump down.

The switchover from using electron column 304 to using an ion beam column (not shown) in chamber 308 can be very quick. The orifice 312 is small enough so that the gas leakage into the system vacuum chamber 308 is small, and gas pressure in chamber 308 can be maintained at a lower level that the pressure in the more open ion generator design of an ESEM detector. To switch from using column 304 to using the ion beam, an operator will typically turn off the gas to the ion generator, and then vent the small ion generator volume to the main chamber. Alternatively, a valve could be placed in orifice 312. In some embodiments, the ion generator gas could be an inert gas (argon, helium, etc.) so the gas could remain flowing during FIB operation, and, when switching to FIB operation, the only change may be removal of the high voltage from the ion generator. In some embodiments, it may be possible to use the ion generator as a gas injector, that is, to direct toward the work piece an etch enhancing gas or a gas that decomposes in the presence of a charged particle beam to deposit a material. Such gases are well known in the art.

A disadvantage of ESEMs is their relatively slow imaging speed, typically less than about 1 microsecond per pixel. By using an ion generator such as ion generator 302, one achieves the benefits of ion generator charge neutralization while being able to use a non-ESEM detector for faster imaging speed. This advantage can also be achieved in a single beam system or a multiple beam system, when at least one column that uses a non-ESEM detector.

Because of the amplification effect of the ion generator, only a relatively small number of secondary particles need to be collected by the ion generator to generate sufficient ions for charge neutralization, and most of the secondary particles are therefore available for collection by the imaging system. When the ion generator is used for charge neutralization and not also as an amplifier for the secondary particle signal, significantly lower amplification can be used. Because the amplification depends on the gas pressure in tube 310, a lower pressure can then be used, which will reduce the pressure in chamber 308.

The appropriate pressure in tube 310 will depend upon the voltage in the ion generator and the number and energy of the captured secondary particles, which factors may vary with the application. To determine an appropriate pressure for a particular embodiment, one can measure the electron signal at the electrode in order to monitor the ion generation and adjust the gas pressure or voltages to achieve sufficient ions to neutralize the substrate. The gas pressure can be reduced in embodiments in which the ions are not used for ESEM-type signal amplification.

Gas pressure in the ion generator 302 is preferably greater than 0.13 mbar (0.1 Torr) and more preferably greater than about 0.39 mbar (0.3 Torr). A preferred pressure in the tube of about 0.65 mbar (0.5 Torr) would allow a large ion multiplication factor. The pressure is preferably less than 1.3 mbar (1.0 Torr) and more preferably less than 0.91 mbar (0.7 Torr). An orifice of about 0.2 mm would restrict the gas flow to keep the chamber in the 1.3x10⁻⁵ mbar (10⁻⁵ Torr) range. The size of the orifice will vary with the system parameters. The orifice should be sufficiently large to allow a significant number of secondary electrons to pass into tube 310 and to allow most of the ions to pass out of the tube 310 orifice. Skilled persons can determine an appropriate orifice size based on the guidance provided above. The pressure in the chamber during operation of the ion generator is preferably less than 1.3x10⁻² mbar (10⁻² Torr), more preferably less than 1.3x10⁻³ mbar (10⁻³ Torr), more preferably less than about 1.3x10⁻⁴ mbar (10⁻⁴ Torr), and most preferably less than or equal to about 1.3x10⁻⁵ mbar (10⁻⁵ Torr).

Gases that are known to be suitable for use in ESEM detectors are typically also suitable gases for use with ion generator 302. Desirable properties of suitable gases include low ionization energy, oxidizing, and non-corrosive. For example, water vapor is a suitable detector gas for amplifying the secondary particle signal. Other suitable gases include nitrogen, argon and carbon monoxide. The detector gas can also be mixed with another gas used in charged particle beam assisted deposition or etching. For example, xenon difluoride enhances etching of several materials including silicon. Ions are attracted to the work piece surface, and, when activated by the charged particle beam, etch the surface. As another example, tungsten hexafluoride and tungsten hexacarbonyl decompose in the presence of an electron beam to deposit tungsten.

In some embodiments, the ion generator in Figure 3 can be used with an immersion lens. The magnetic field from the lens will normally inhibit the secondary electrons from reaching the ion generator tube. In this case, it is possible place the ion generator in a position such that high energy backscattered electrons (that can escape from the magnetic field) enter the tube and trigger the ion generation process. The magnetic field will not significantly affect the ion flow out. This configuration of ion generator would allow the use of so called "through the lens" detectors that operate in a high vacuum, and are integral with, or above the immersion lens.

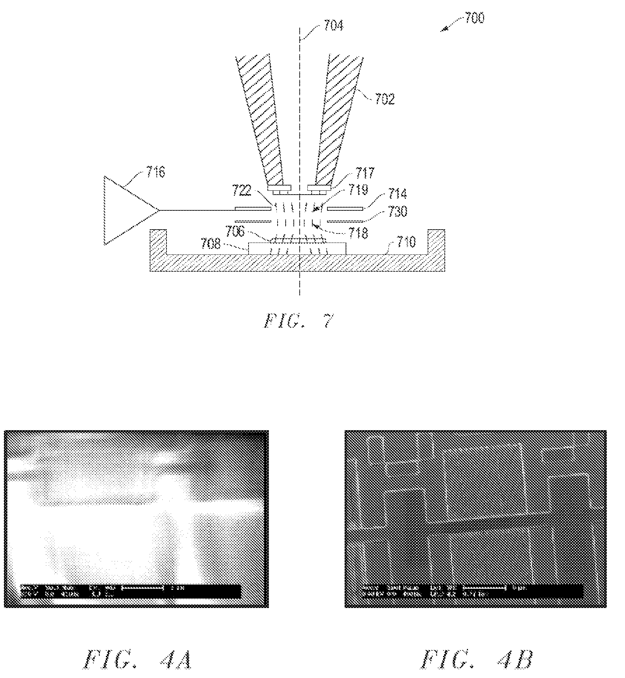

FIGS 4A and 4B show an electron beam image of a binary mask, with FIG. 4A showing the image obtained when the mask is electrically charged due to the electron beam (without any charge neutralization) and FIG. 4B showing the image obtained when the charge on the mask is neutralized in accordance with an embodiment of the invention

The embodiment of FIG. 3 uses a localized high pressure region in tube 310 for ion generation, so that the vacuum chamber can be maintained at a much lower pressure. The examples (not forming part of the invention) described below combine the concept of localized high pressure with the use of ESEM detection with an immersion lenses. The examples described below allow effective electron detection and electron beam charge control while maintaining low chamber pressure, which is preferred for electron beam chemistry and dual beam operation with highly insulating samples. Local pressures in the ion generation zones and chamber pressures away from the ion detectors are preferably similar to those described above with respect to a system using ion generator 302.

Whereas the embodiment of FIG. 3 uses an ion generator that is separate from a detector, the examples (not forming part of the invention) below use an ion generator that is also used for secondary particle detection. These examples allow ESEM-like secondary particle detection, as well as charge control and chemically enhanced charged particle beam operations, particularly when used with a magnetic immersion objective lens. Some examples shown provide improved signal amplification and charging control by using a specific combination of a magnetic field and electrostatic field, in conjunction with a gaseous environment. Several such configurations are described in more detail in US2004124356A entitled "Particle-optical device and detection means," by Scholtz et al., filed concurrently herewith by the assignee of the present application.

Japanese Pat. Publication No. 5-174768 shows a column configuration in which a magnetic field from an objective lens is parallel to the electric field, and the application claims that the secondary electrons are trapped around the magnetic flux lines, thereby increasing the path length and amplification. "Particle-optical device and detection means" described above shows that a longer path length can be provided by suitable choice of the electric field shape to implement the so called "magnetic Penning mechanism." This longer path length is in the form of a damped oscillation. One can also configure an electrode such that the electric field includes a component that is orthogonal to the magnetic field. Such a configuration is similar to a structure known as a "magnetron," in which electrons travel in a circular orbit in the presence of a radial electric field perpendicular to a magnetic field. This configuration can greatly extend the electron path length and provide large gaseous amplification in the presence of gas.

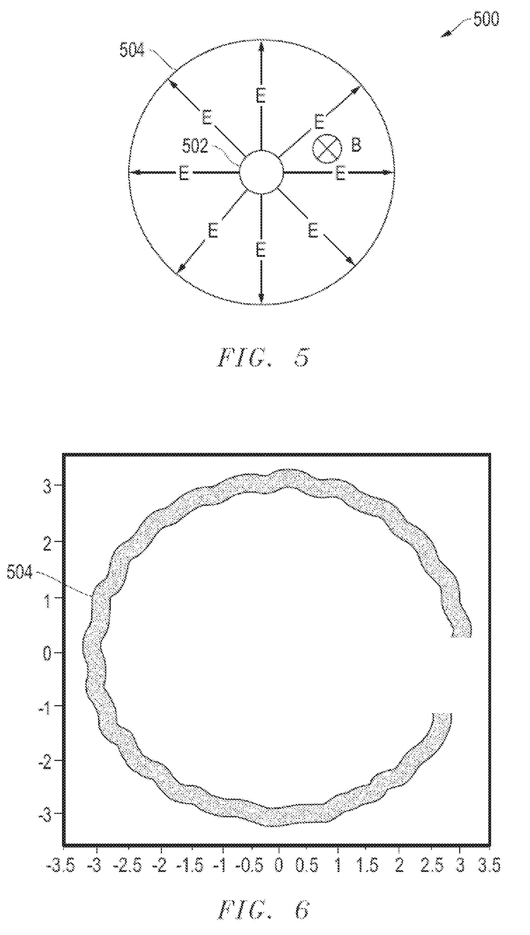

To illustrate the principle, FIG. 5 shows a magnetron structure 500 that consists of two coaxial, cylindrical electrodes, an inner cylinder 502 and an outer cylinder 504. Inner cylinder 502 is grounded, and the outer cylinder 504 is at a positive potential. This potential difference produces a radial electric field between the two electrodes, as illustrated by arrows labeled "E". In addition, there is a magnetic field labeled B, perpendicular to and directed into the plane of the page as indicated by the circled X and preferably uniform throughout the space between the cylinders. An electron that starts at a place between the two electrodes will follow a path similar to that illustrated in FIG. 6.

In a high vacuum, with the right values of electric field (E) and magnetic field (B), the electron can move around the structure indefinitely. However, if there is gas present then the electron will collide with a gas molecule. If the energy of the electron is high enough then the gas molecule may be ionized, and two electrons are then present. These two electrons will start to move further out towards electrode 504 and will then move around electrode 502 in a similar path to FIG. 6, but with a larger radius. These two electrons may further collide with gas molecules to repeat the cascade process. The increased path length can generate great amplification. It may be shown, however, that the maximum amplification will only occur with the appropriate combinations of the magnetic field, B, and electrostatic field, E.

The combination of the two effects, that is, the magnetic Penning effect from the component of electric field parallel to the magnetic field and the "magnetron" effect from the component of the electric field orthogonal to the magnetic field, creates a greatly enhanced amplification of the signal. To achieve amplification simultaneously using both methods in a single apparatus requires specific combinations of three primary parameters: gas pressure, magnetic field strength, and electric field strength.

FIG. 7 shows an example not forming part of the invention, comprising a charged particle beam system 700 having an immersion lens 702 that focuses an electron beam 704 onto a work piece 706 resting on a stage 708 that rests on a second pole 710 of the immersion lens. System 700 uses as a detector an electrode plate 714 connected to amplifier 716. A separation diaphragm 717 maintains a pressure difference between a detection space 718 between work piece 706 and detector 714 by reducing gas flow into the upper column. Electrode plate 714 is preferably a simple, thin conductive plate having a substantially round central aperture 719 that is substantially coaxial with a magnetic field 722. A positive voltage, in the range of 100 V to 2000 V may be applied to the electrode plate 714 during operation. The bias on electrode plate 714 produces an electric field that, because of aperture 719, is in part parallel, and in part orthogonal to the magnetic field 722 produced by immersion lens 702, and system 700 can therefore achieve secondary particle signal amplification by way of the magnetic Penning and magnetron effects described above.

A large diameter aperture 719 will produce an electric field close to the electrode 714 that is orthogonal to the magnetic field 722, thereby providing a region that can achieve amplification by the magnetron effect. If the hole is too small, however, then the magnetron effect does not occur. If the aperture is too big, however, the enhancement due to the magnetic Penning effect does not occur. Certain hole diameters, together with the certain corresponding values of magnetic field, electric field, and gas pressure, can achieve both amplification mechanisms simultaneously. When these conditions are satisfied, the amplified signal from magnetic Penning mechanism is then compoundly amplified by the magnetron mechanism to achieve a correspondingly large overall amplification.

The amplification of the secondary electron signal also produces positive ions which are needed to avoid the charging of the sample. However, the very large amplification produced by the two mechanism described above may create too many ions. An additional plate 730, which may be grounded, or may be biased, can be provided to collect the excess ions. This plate may also be connected to an amplifier to provide a detected signal.

There are many combinations of hole diameters, magnetic field strengths, electric field strengths, and gas pressures that will achieve the compound mechanism. However, for any specific hole diameter, only certain combinations of bias voltage and magnetic field will produce the compound effect.

Amplification due to the magnetic Penning mechanism will occur only when the peak electric potential along the axis of the electron beam exceeds the ionization potential of the gas. Amplification due to the magnetron effect will only occur if the radial electric field (E) and the magnetic field (B) are such that 2*m*(E/M)^2/q is greater than the ionization energy of the gas, where m is the mass of an electron and q is the charge of an electron. Skilled persons can use this guidance to determine appropriate diameters for a particular application. As an example, a high amplification of more than 5000 can be provided with an anode hole diameter of 3mm, anode voltage of 400V and a pressure of 0.39 mbar (0.3 Torr) of water vapor.

By achieving a large overall amplification, the distance from the work piece to the detector can be kept short, which decreases the working distance of the lens and increases its resolution. Also, the gas pressure at the detector can be reduced, which reduces the overall gas pressure in the chamber, thereby decreasing or eliminating the time require switch from ESEM operation to FIB or other non-ESEM beam operation. The pressure in detector space 718 can be reduced from about 0.65 mbar (0.5 Torr) to about 0.39 mbar (0.3 Torr) or lower, or even, for some embodiments, to 0.13 mbar (0.1 Torr) or lower. Reducing the gas pressure at the collector further reduces the gas pressure in the vacuum chamber away from the detector.

When the work piece has a suitable shape, for example, a large, flat object, such as a photolithography mask or a semiconductor wafer, and the detector is placed close to the work piece, the geometry provides some confinement to the gas in the area in which amplification occurs. The gas pressure therefore tends to remain greater in the space between the detector and the work piece, and lower in the chamber away from the detector. Some examples provide an operating pressure of one or more tenth of a mbar (one or more tenths or a Torr) in the amplification zone, while maintaining a reduced pressure in the vacuum chamber in general. Gas pressures in the amplification zone and in the remainder of the vacuum chamber can be similar to those described with respect to the system of FIG. 3, although the chamber pressure will typically be somewhat higher using an ESEM detector, because the gas is less confined.

Thus, the ESEM detector can operate in a vacuum chamber containing another charged particle beam system, with the detector gas interfering minimally or not at all with the other charged particle beam column, or with the gas pressure in the chamber being raised to an extent at which the chamber can be evacuated relatively quickly to operate the other column.

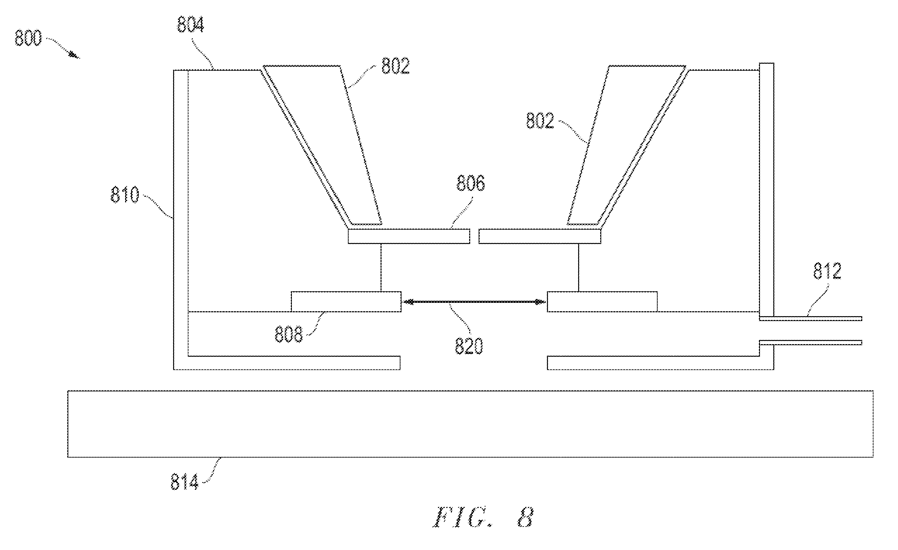

The example of FIG. 8 (not forming part of the invention) shows a lower portion of an electron beam system 800 that includes a magnetic immersion lens 802 and that uses the secondary particle signal amplification principals described above. System 800 provides enhanced gas isolation to localize the gas and to reduce interference with the operation of other charged particles beam column in the same vacuum chamber. System 800 includes an insulator 804 that supports a pressure limiting aperture 806 and an annular detector electrode 808. An ion trap 810 surrounds the assembly including the detector electrode 808, the insulator 804, the tip of immersion lens 802, and the pressure-limiting aperture 806. The work piece 814 is placed close to underside of the ion trap. A pipe 812 is used to supply gas into the detection region. A small amount of gas escapes into the electron column through pressure limiting aperture 806, but the flow is low enough that the electron column may be maintained at the required high vacuum level. A small amount of gas also passes between the ion trap and the sample, but the flow is again low enough that the vacuum pump on the sample chamber can maintain a very low gas pressure in the chamber.

A hole 820 in the detector 808 for the gas to exit preferably has a diameter on the order of magnitude of millimeters, depending upon the system parameters. The user alters the magnetic field of the immersion lens when the image is focused. The potential on the detector can then be adjusted, either automatically or manually, to create the required electric field, and optimize the detector gain. Lens 802 provides the required magnetic field in the throughout the detection region.

Typical gaseous detectors use with the magnetic immersion lens perform optimally at a gas pressure of about 0.65 mbar (0.5 Torr) of gas pressure in the chamber and in the path of the primary beam. This example produces the improved signal amplification and charging control described above, but also provides for operation at much lower chamber pressures by concentrating the gas in the region where the amplification occurs. This example is particularly appropriate to the imaging or modification of photomasks or other similar work pieces that are flat, and large in diameter.

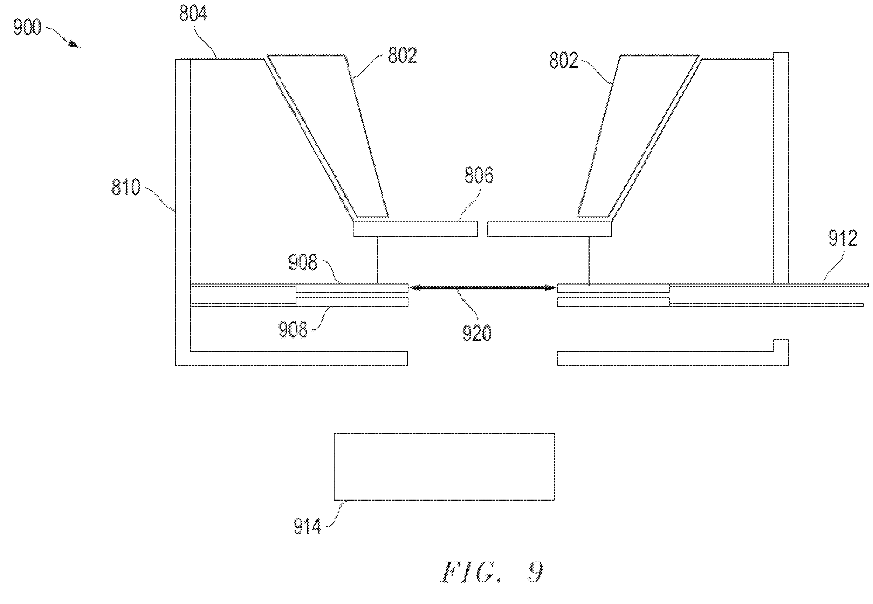

The example of FIG. 9 (not forming part of the invention) shows a lower portion of an electron beam system 900 that is very similar to that shown in FIG. 8, and similar elements have the same designation. System 900 is more suitable for imaging or modifying of small or irregularly shaped samples. System 900 localizes the gas by a different method. The detector electrode comprises two plates 908, with the gas flowing in between the two plates from an external source through pipe 912. Applicants have found that the main signal amplification and ion generation happens in the region of intense electric field close to the detector electrode. In this example, the electrode is hollow so that gas can be passed through the electrode into the detection region. This creates a high gas pressure close to the electrode, giving high amplification and high ion generation. The gas will then expand into the rest of the region, so that the gas pressure at the beam axis is much lower. This is a major advantage because the gas in the beam path creates a "skirt" of off-axis electrons (particularly at low beam voltages) which have several undesirable results:
the off axis electrons create a background signal in the electron image and reduce image contrast;
the off-axis electrons will cause etching/deposition outside of the beam impact area in e-beam chemistry.

By reducing the gas in the beam path, these undesirable results are reduced or eliminated.

Another major advantage of this design for dual beam applications on irregular shaped samples is that the chamber pressure is much lower so that the changeover time between e-beam operation and ion beam operation will be reduced.

One can shape the detector electrode or the hole in the ion trap or add a bias to the ion trap such as to preferentially control the flow of ions through the hole in the ion trap onto the sample. Embodiments can be used not only to neutralize charge, but also to control an electrical bias on the mask or other work piece. Controlling the bias can provide for optimum imaging and can improve the use of beam chemistry, that is, the use of gases to deposit material or to enhance etching.

The embodiments above described maintain the gas at a sufficient pressure in the ionization region to support adequate ionization by secondary particles, yet maintain the pressure in the rest of the chamber that is either low enough to allow, or be evacuated rapidly to allow, the use of gases directed toward the work piece for charged particle beam deposition or chemically-enhanced charged particle beam etching. The pressure is also low enough in other parts of the vacuum chamber so as to not interfere with the operation of the primary beam columns.

Although the invention is not limited to any particular application, some embodiments are particularly useful for repairing lithography masks, especially masks used for the 70 nm lithography node and beyond, including optical, x-ray, extreme ultra violet (EUV), different absorbers, and alternating phase shift masks (APSM) technologies.

Although the present invention and its advantages have been described in detail, it should be understood that various changes, substitutions and alterations can be made herein without departing from the invention as defined by the appended claims. Moreover, the scope of the present application is not intended to be limited to the particular embodiments of the process, machine, manufacture, composition of matter, means, methods and steps described in the specification.

## Claims

1. A charged particle beam apparatus (100, 150) comprising:
a work piece vacuum chamber (110, 160, 308) for containing a work piece and having a background chamber pressure;
a charged particle beam source;
a charged particle beam optical column (102, 104, 152, 154, 304) for directing a particle beam (306) along an optical axis toward the work piece;
an ion generator (122, 156, 302);
in which secondary particles (320) generated by the impact of charged particle beam on a work piece (307) or particles from the primary beam backscattered by the work piece ionize an ion producing gas, the ion generator positioned such that at least some of the ions travel to the work piece to neutralize charge on the work piece, the ion generator including an enclosed tube (310) containing said ion producing gas, a high voltage electrode (317) for accelerating secondary particles within the enclosed tube, and an orifice (312) in an end of the enclosed tube which connects the enclosed tube to the work piece vacuum chamber, said orifice allowing secondary or backscattered particles from the work piece to enter the chamber and allowing ions to exit the chamber to neutralize charge on the work piece;
**characterized by** a pipe (318) in fluidic communication with the enclosed tube, the pipe adapted for conveying the ion producing gas (319) to the enclosed tube; and in that the orifice (312) is small enough to maintain within the enclosed tube a localized high pressure region for ion generation while maintaining the background chamber pressure a pressure much lower than the localized high pressure region within the enclosed tube.

2. The charged particle beam apparatus of claim 1 in which the charged particle beam optical column includes an objective lens (305) and an optical axis and in which the ion generator is positioned such that a line drawn from the center of the orifice to the intersection of the optical axis with the work piece is not parallel to the optical axis.

3. The charged particle beam apparatus of claim 1 in which the charged particle beam optical column comprises a scanning electron microscope column.

4. The charged particle beam apparatus of any of claims 1-3 in which the ion generator is adapted to use a gas ionization cascade in the enclosed tube.

5. The charged particle beam apparatus of any of claims 1-3 in which the charged particle beam column includes a magnetic immersion objective lens (207).

6. A method of operating the charged particle beam system of any of claims 1-5, the method comprising:
directing the charged particle beam along an optical axis towards the work piece;
maintaining within the enclosed tube a localized high pressure region for ion generation while maintaining the work piece vacuum chamber at a much lower pressure;
attracting some of secondary electrons (320) by a small positive bias voltage on the enclosed tube (310) and further accelerating the secondary electrons by the high voltage electrode (317) to trigger gas ionization cascades in the enclosed tube; and
accelerating ions created by the ionization of the gas in the enclosed tube to neutralize at least a portion of the electrical potential on the surface of the work piece.

7. The method of claim 6 when referring back to claim 2 further comprising controlling the number of ions that impinges on the work piece by biasing or grounding an electrode outside of the enclosed tube to cause ions to flow to the electrode instead of the objective lens (305).

8. The method of claim 6 or claim 7 further providing in the enclosed tube a mixture of said ion producing gas and a gas for charged particle beam assisted deposition or etching.

9. The method of claim 8 in which the ion generator is configured such that the ion producing gas is maintained at a sufficiently high pressure at the ion generator to produce sufficient ions from the secondary or backscattered particles to neutralize charge accumulation on the work piece, while the background chamber pressure remains at a significantly lower pressure.

10. The method of claim 9 in which the ion producing gas is maintained at a pressure greater than 0.1 Torr (0,133hPa) and in which the background chamber pressure is maintained at a pressure of less than 0.01 Torr (0,0133hPa).

11. The method of claim 9 in which the ion producing gas is maintained at a pressure greater than 0.3 Torr (0,4hPa) and in which the background chamber pressure is maintained at a pressure of less than 10⁻³ Torr (1,33, 10⁻³hPa).

12. The method of claim 9 in which the ion producing gas is maintained at, a pressure greater than 0.4 Torr (0,532hPA) and in which the background chamber pressure is maintained at a pressure of less than 10⁻³ Torr (1,33, 10⁻³hPa).

## Patentansprüche

1. Ladungsteilchenstrahlvorrichtung (100, 150) mit:
einer Werkstückvakuumkammer (110, 160, 308) zur Aufnahme eines Werkstücks und mit einem Hintergrundkammerdruck;
einer Ladungsteilchenstrahlquelle;
einer optischen Ladungsteilchenstrahlsäule (102, 104, 152, 154, 304) zum Richten eines Teilchenstrahls (306) entlang einer optischen Achse in Richtung des Werkstücks;
einem Ionengenerator (122, 156, 302), bei dem durch den Aufprall des Ladungsteilchenstrahls auf ein Werkstück (307) erzeugte Sekundärteilchen (320) oder durch das Werkstück zurückgestreute Teilchen aus dem Primärstrahl ein Ionen erzeugendes Gas ionisieren, wobei der Ionengenerator so positioniert ist, dass zumindest einige der Ionen zum Werkstück wandern, um die Ladung des Werkstücks zu neutralisieren, wobei der Ionengenerator eine geschlossene Röhre (310) aufweist, die das Ionen erzeugende Gas, eine Hochspannungselektrode (317) zum Beschleunigen von Sekundärteilchen in der geschlossenen Röhre und eine Öffnung (312) in einem Ende der geschlossenen Röhre enthält, die die geschlossene Röhre mit der Werkstückvakuumkammer verbindet, wobei durch die Öffnung Sekundär- oder Rückstreuteilchen vom Werkstück in die Kammer eindringen können, sodass Ionen aus der Kammer austreten können, um die Ladung des Werkstücks zu neutralisieren;
**gekennzeichnet durch** ein Rohr (318) in Fluidverbindung mit der geschlossenen Röhre, wobei das Rohr zum Transport des Ionen erzeugenden Gases (319) in die geschlossene Röhre geeignet ist; und **dadurch**, dass die Öffnung (312) klein genug ist, um in der geschlossenen Röhre einen lokal begrenzten Hochdruckbereich zur Ionenerzeugung aufrechtzuerhalten und gleichzeitig den Hintergrundkammerdruck als einen Druck aufrechtzuerhalten, der viel niedriger ist als der lokal begrenzte Hochdruckbereich in der geschlossenen Röhre.

2. Ladungsteilchenstrahlvorrichtung nach Anspruch 1, in der die optische Ladungsteilchenstrahlsäule eine Objektivlinse (305) und eine optische Achse aufweist und in der der Ionengenerator so positioniert ist, dass eine von der Mitte der Öffnung bis zur Überschneidung der optischen Achse mit dem Werkstück gezogene Linie nicht parallel zur optischen Achse ist.

3. Ladungsteilchenstrahlvorrichtung nach Anspruch 1, in der die optische Ladungsteilchenstrahlsäule eine Rasterelektronenmikroskopsäule aufweist.

4. Ladungsteilchenstrahlvorrichtung nach einem der Ansprüche 1 bis 3, in der der Ionengenerator geeignet ist, eine Gasionisierungskaskade in der geschlossenen Röhre zu verwenden.

5. Ladungsteilchenstrahlvorrichtung nach einem der Ansprüche 1 bis 3, in der die Ladungsteilchenstrahlsäule eine magnetische Immersionsobjektivlinse (207) aufweist.

6. Verfahren zum Betreiben des Ladungsteilchenstrahlsystems nach einem der Ansprüche 1 bis 5, wobei das Verfahren umfasst:
Richten des Ladungsteilchenstrahls entlang einer optischen Achse zum Werkstück;
Aufrechterhalten eines lokal begrenzten Hochdruckbereichs zur Ionenerzeugung in der geschlossenen Röhre und gleichzeitiges Halten der Werkstückvakuumkammer auf einem viel niedrigeren Druck;
Anziehen einiger Sekundärelektronen (320) durch eine kleine positive Vorspannung an der geschlossenen Röhre (310) und weiteres Beschleunigen der Sekundärelektronen durch die Hochspannungselektrode (317), um Gasionisierungskaskaden in der geschlossenen Röhre auszulösen; und
Beschleunigen von durch die Ionisierung des Gases erzeugten Ionen in der geschlossenen Röhre, um zumindest einen Teil des elektrischen Potenzials an der Oberfläche des Werkstücks zu neutralisieren.

7. Verfahren nach Anspruch 6 unter Rückbezug auf Anspruch 2, ferner umfassend: Steuern der Anzahl von Ionen, die auf dem Werkstück auftreffen, durch Vorspannung oder Erdung einer Elektrode außerhalb der geschlossenen Röhre, um zu bewirken, dass Ionen zur Elektrode statt zur Objektivlinse (305) fließen.

8. Verfahren nach Anspruch 6 oder 7, wobei ferner in der geschlossenen Röhre ein Gemisch aus dem Ionen erzeugenden Gas und einem Gas zur ladungsteilchenstrahlgestützten Aufbringung oder Ätzung bereitgestellt wird.

9. Verfahren nach Anspruch 8, in dem der Ionengenerator so konfiguriert ist, dass das Ionen erzeugende Gas im Ionengenerator auf einem ausreichend hohen Druck gehalten wird, um genügend Ionen aus den Sekundär- oder Rückstreuteilchen zu erzeugen, um die Ladungsansammlung im Werkstück zu neutralisieren, während der Hintergrundkammerdruck auf einem deutlich niedrigeren Druck verbleibt.

10. Verfahren nach Anspruch 9, in dem das Ionen erzeugende Gas auf einem Druck von mehr als 0,1 Torr (0,133 hPa) gehalten wird und in dem der Hintergrundkammerdruck auf einem Druck von weniger als 0,01 Torr (0,0133 hPa) gehalten wird.

11. Verfahren nach Anspruch 9, in dem das Ionen erzeugende Gas auf einem Druck von mehr als 0,3 Torr (0,4 hPa) gehalten wird und in dem der Hintergrundkammerdruck auf einem Druck von weniger als 10⁻³ Torr (1,33 · 10⁻³ hPa) gehalten wird.

12. Verfahren nach Anspruch 9, in dem das Ionen erzeugendes Gas auf einem Druck von mehr als 0,4 Torr (0,532 hPa) gehalten wird und in dem der Hintergrundkammerdruck auf einem Druck von weniger als 10⁻³ Torr (1,33 · 10⁻³ hPa) gehalten wird.

## Revendications

1. Appareil à faisceau de particules chargées (100, 150) comportant :
une chambre à vide pour pièce à usiner (110, 160, 308) pour contenir une pièce à usiner et possédant une pression de fond de chambre ;
une source de faisceau à particules chargées ;
une colonne optique de faisceau à particules chargées (102, 104, 152, 154, 304) pour diriger un faisceau de particules (306) le long d'un axe optique vers la pièce à usiner ;
un générateur d'ions (122, 156, 302)
dans lequel des particules secondaires (320) générées par l'impact du faisceau à particules chargées sur une pièce à usiner (307) ou des particules provenant du faisceau primaire rétrodiffusées par la pièce à usiner ionisent un gaz produisant des ions, le générateur d'ions étant positionné de sorte qu'au moins certains des ions se déplacent vers la pièce à usiner pour neutraliser une charge sur la pièce à usiner, le générateur d'ions comprenant un tube hermétique (310) contenant ledit gaz et produisant des ions, une électrode à tension élevée (317) pour accélérer les particules secondaires à l'intérieur du tube hermétique, et un orifice (312) à une extrémité du tube hermétique qui relie le tube hermétique à la chambre à vide pour pièce à usiner, ledit orifice permettant aux particules secondaires rétrodiffusées provenant de la pièce à usiner de pénétrer dans la chambre et permettant aux ions de sortir de la chambre pour neutraliser une charge sur la pièce à usiner ;
**caractérisé par** un tuyau (318) en communication fluidique avec le tube hermétique, le tuyau étant adapté pour transporter le gaz produisant des ions (319) vers le tube hermétique ; et en ce que l'orifice (312) est suffisamment petit pour maintenir dans le tube hermétique une région à haute pression localisée pour générer des ions tout en maintenant la pression de fond de chambre une pression beaucoup plus faible que la région à haute pression localisée dans le tube hermétique.

2. Appareil à faisceau de particules chargées selon la revendication 1, dans lequel la colonne optique à faisceau de particules chargées comprend une lentille d'objectif (305) et un axe optique et dans lequel le générateur d'ions est positionné de sorte qu'une ligne tracée du centre de l'orifice à l'intersection de l'axe optique avec la pièce à usiner n'est pas parallèle à l'axe optique.

3. Appareil à faisceau de particules chargées selon la revendication 1, dans lequel la colonne optique à faisceau de particules chargées comporte une colonne à microscope électronique à balayage.

4. Appareil à faisceau de particules chargées selon l'une quelconque des revendications 1-3, dans lequel le générateur d'ions est adapté pour utiliser une cascade d'ionisation de gaz dans le tube hermétique.

5. Appareil à faisceau de particules chargées selon l'une quelconque des revendications 1-3, dans lequel la colonne à faisceau de particules chargées comprend une lentille d'objectif à immersion magnétique (207).

6. Procédé de fonctionnement du système de faisceau à particules chargées selon l'une quelconque des revendications 1-5, le procédé comportant :
l'orientation du faisceau à particules chargées le long d'un axe optique vers la pièce à usiner ;
le maintien à l'intérieur du tube hermétique d'une région à haute pression localisée pour générer des ions tout en maintenant la chambre à vide pour pièce à usiner à une pression beaucoup plus faible ;
l'attraction de certains des électrons secondaires (320) par une faible tension de polarisation positive sur le tube hermétique (310) et en outre l'accélération des électrons secondaires par l'électrode à tension élevée (317) pour déclencher des cascades d'ionisation de gaz dans le tube hermétique ; et
l'accélération des ions créés par l'ionisation du gaz dans le tube hermétique pour neutraliser au moins une partie du potentiel électrique sur la surface de la pièce à usiner.

7. Procédé selon la revendication 6 avec référence à la revendication 2, comportant en outre le contrôle du nombre d'ions qui sont incidents sur la pièce à usiner en polarisant ou en mettant à la masse une électrode à l'extérieur du tube hermétique pour amener les ions à circuler vers l'électrode au lieu de la lentille d'objectif (305).

8. Procédé selon la revendication 6 ou la revendication 7, délivrant en outre dans le tube hermétique un mélange dudit gaz produisant des ions et d'un gaz pour un dépôt assisté par faisceau de particules chargées ou une gravure.

9. Procédé selon la revendication 8, dans lequel le générateur d'ions est configuré de sorte que le gaz produisant des ions est maintenu à une température suffisamment élevée dans le générateur d'ions pour produire suffisamment d'ions à partir des particules secondaires ou rétrodiffusées afin de neutraliser une accumulation de charge sur la pièce à usiner, alors que la pression de fond de chambre reste à une pression significativement plus faible.

10. Procédé selon la revendication 9, dans lequel le gaz produisant des ions est maintenu à une pression supérieure à 0,1 Torr (0,133hPa) et dans lequel la pression de fond de chambre est maintenue à une pression inférieure à 0,01 Torr (0,0133hPa).

11. Procédé selon la revendication 9, dans lequel le gaz produisant des ions est maintenu à une pression supérieure à 0,3 Torr (0,4hPa) et dans lequel la pression de fond de chambre est maintenue à une pression inférieure à 10⁻³ Torr (1,33, 10⁻³hPa).

12. Procédé selon la revendication 9, dans lequel le gaz produisant des ions est maintenu à une pression supérieure à 0,4 Torr (0,532hPa) et dans lequel la pression de fond de chambre est maintenue à une pression inférieure à 10⁻³ (1,33, 10⁻³hPa).
